# EUROPÄISCHE PATENTSCHRIFT

(11) **EP 1 046 921 B1**
(45) Veröffentlichungstag und Bekanntmachung des Hinweises auf die Patenterteilung: **16.11.2005**
(21) Anmeldenummer: 00108444.1
(22) Anmeldetag: 17.04.2000
(51) Int. Cl.: G01R 31/316, G11C 29/00

(54) **Anordnung zur Durchführung von Burn-In-Behandlungen von Halbleitervorrichtungen auf Waferebene**
Apparatus for carrying out Burn-in procedures of semiconductor devices on wafer planes
Appareil pour réaliser des tests de viellissement de dispositifs semi-conducteurs dans un plan d'une plaquette semi-conductrice

(30) Priorität: 19.04.1999 DE 19917586
(43) Veröffentlichungstag der Anmeldung: 25.10.2000
(73) Patentinhaber: Infineon Technologies AG, 81669 München (DE)
(72) Erfinder: Pöchmüller, Peter, Dr., 81739 München (DE)
(74) Vertreter: Müller - Hoffmann & Partner

(56) Entgegenhaltungen:
- EP-A- 0 699 912
- US-A- 5 489 538
- US-A- 5 838 163
- US-A- 5 899 703

## Beschreibung

Die vorliegende Erfindung betrifft ein System zur Durchführung von Burn-In-Behandlungen von Halbleitervorrichtungen auf Waferebene, bei der ein eine Vielzahl von Halbleiterchips enthaltender Halbleiterwafer einem Burn-In unterworfen wird, durch den die in den Halbleiterchips realisierten integrierten Schaltungen und Bauteile bei erhöhter Temperatur bestimmten, von außen zugeführten Spannungen ausgesetzt sind.

Burn-In-Behandlungen von Halbleitervorrichtungen, wie beispielsweise Chips, stellen deren künstliche Alterung dar. Durch eine solche künstliche Alterung wird die Halbleitervorrichtung in einen Zustand versetzt, die sie sonst erst nach einer relativ langen Betriebsdauer erreichen würde. Dadurch ist es möglich, im Anschluss an einen Burn-In alle die Halbleitervorrichtungen auszusortieren, die sich nach dem Burn-In als fehlerhaft erweisen. Mit anderen Worten, ein Burn-In bietet die Möglichkeit, solche Halbleitervorrichtungen vor einem Einbau in Geräte zu verwerfen, welche sonst nach der genannten relativ langen Betriebsdauer ausfallen würden.

Bei einem Burn-In werden Halbleitervorrichtungen bei erhöhten Temperaturen, beispielsweise 140°C, bestimmten Belastungstests unterworfen, indem der Halbleitervorrichtung vorgegebene Spannungsmuster aufgeprägt werden. So können beispielsweise dynamische Randomspeicher (DRAMs) einer zyklischen Belastung der Wortleitungen ("wordline cycling") ausgesetzt werden.

Burn-In Behandlungen sind also praktisch unverzichtbar, wenn an Kunden Halbleitervorrichtungen ausgeliefert werden sollen, deren Zuverlässigkeit über eine lange Betriebsdauer gewährleistet ist: Die Burn-In-Behandlungen eröffnen die Möglichkeit, gegebenenfalls fehlerhaft werdende Halbleitervorrichtungen vor deren Auslieferung an Kunden auszusortieren, so dass das Auftreten von Fehlern nach dem Einbau der Halbleitervorrichtungen in die bestimmungsgemäßen Geräte zu vermeiden ist.

Bisher werden Burn-In-Behandlungen nur auf Chip-Ebene und nicht auf Wafer-Ebene durchgeführt, da bei einem Burn-In eines Chips mittels etwa 60 Anschlüssen an definierten Anschlüssen des Chips Spannung angelegt werden muss und derzeit Nadelkarten mit mehr als 1500 Nadeln nicht erhältlich sind. Ein Wafer weist aber etwa 1000 Chips auf, was für eine Burn-In-Behandlung auf Waferebene Nadelkarten mit etwa 60.000 Nadeln erfordern würde. Diese Voraussetzung liegt aber mehr als eine Größenordnung über den derzeit verfügbaren Nadelkarten mit etwa 1500 Nadeln.

Burn-In-Behandlungen auf Chipebene sind mit bestimmten Nachteilen behaftet, weshalb seit langer Zeit ein erheblicher Bedarf für Burn-In auf Waferebene besteht. Diese Nachteile können wie folgt zusammengefasst werden:
- Bei Burn-In auf Chipebene sind die Halbleitervorrichtungen in Kunststoff eingegossen. Werden Fehler nach dem Burn-In erkannt, so können sie nicht repariert werden. Dies ist beispielsweise bei Speichervorrichtungen wie DRAMs mit redundanten Schaltungen besonders nachteilhaft, welche an sich durch Laser-Fusing bzw. Durchbrennen von Fuses aktiviert werden könnten, um ausgefallene Zellen zu ersetzen und damit für eine Reparatur zu sorgen. Eine derartige Reparatur von erfassten Fehlern ist aber nur möglich, solange das Eingießen des Chips in Kunststoff oder ein anderes Gehäuse noch nicht realisiert worden ist.
- Ein herkömmliches Burn-In erfordert es, Komponenten in gesonderte Fassungen einzubauen, welche während des Burn-In kontaktiert werden. Derartige Fassungen werden häufig wieder verwendet und während des Burn-In hohen Temperaturen ausgesetzt. Durch diese häufige Wiederverwendung der Fassungen treten Kontaktierungsprobleme allgemeiner Art auf, was zu einer Minderung der Ausbeute führen kann und jedenfalls ein häufiges Überprüfen und Umbauen von Burn-In-Boards bzw. -Feldern erforderlich macht.
- Obwohl Burn-In-Behandlungen möglichst gleichmäßig und parallel ausgeführt werden, verursachen sie beträchtliche Ausrüstungskosten, welche nicht zuletzt auf die langen Burn-In-Zeiten in der Größenordnung von einigen Stunden zurückzuführen sind.
- Funktionelle Testprogramme werden derzeit möglichst in den Burn-In-Ofen verlegt, da damit aufwendige Testeinrichtungen eingespart und die Produktqualität gesteigert werden kann. Infolge des bereits erwähnten Parallelbetriebs beim Burn-In, bei dem beispielsweise 16 Halbleitervorrichtungen mit dem gleichen Adressbus verbunden sind, sind Signale infolge der hohen kapazitiven Last langsam, was wiederum die Behandlungszeit ungünstig beeinflusst. Auch ist es kaum möglich, eine einzelne defekte Halbleitervorrichtung zu erfassen, da die gewonnene Information lediglich anzeigt, dass eine der beispielsweise 16 Halbleitervorrichtungen einen Fehler aufweist.

Aus den genannten Gründen wurden immer wieder Versuche unternommen, Burn-In-Behandlungen auf Waferebene ("wafer level burn-in" bzw. "WLBI") anzuheben. Das heißt, bei WLBI erfolgt der Burn-In am gesamten Wafer, bevor dieser in einzelne Chips zerlegt wird und diese in Kunststoff eingegossen werden.

Da WLBI mittels Nadelkarten aus den genannten Gründen nicht möglich ist, wurden bisher grundsätzlich die folgenden beiden Möglichkeiten in Erwägung gezogen:
- Es werden herkömmliche Kontaktierungsmethoden herangezogen, bei denen Bonddrähte, die entsprechend geformt sind, als dünne Sondennadeln verwendet werden. Der Wafer wird dann mit einer mit solchen Bonddrähten versehenen Platte in Berührung gebracht.
- Bei einem unkonventionellen Vorgehen wird beispielsweise eine "Gore Mate" eingesetzt, die an sich aus einem Isolator besteht, in welchen dünne Metallkugeln aus beispielsweise Gold eingearbeitet sind, die einander nicht berühren. Wird diese "Gore Mate" zwischen einen Wafer und eine entsprechend gestaltete Kontaktstruktur gepresst, so kann davon ausgegangen werden, dass die Metallkugeln Kontakte herstellen, solange die Kontaktkissen ausreichend groß sind und der Abstand zwischen Metallkugeln hinreichend klein bleibt.

In der US 5,489,538 ist ein Verfahren zur Burn-In-Behandlung beschrieben, bei welchem BIST-Einheiten zur Anwendung gelangen. Chipränder grenzen wohl an Sägeränder (Kerfs) an, in denen Leiterbahnen geführt sind, die beim Burn-In verwendet werden, und die Pads aufweisen, mit denen eine Verdrahtung vorgenommen werden kann.

Weiterhin beschreibt die US 5,838,163 eine Padanordnung für Wafer, bei der ebenfalls Leiterbahnen im Kerf geführt sind und ein Burn-In mittels BIST vorgenommen wird.

Keine dieser bisher angedachten Methoden schafft aber eine zuverlässige und flächenoptimierte Möglichkeit zur Durchführung von Burn-In-Behandlungen von Halbleitervorrichtungen auf Waferebene.

Es ist Aufgabe der vorliegenden Erfindung, ein System zur Durchführung von Burn-In-Behandlungen von Halbleitervorrichtungen zu schaffen, welche flächenoptimiert und zuverlässig auf Waferebene eingesetzt werden kann.

Diese Aufgabe wird bei einer Anordnung der eingangs genannten Art erfindungsgemäß gelöst durch wenigstens eine im Halbleiterwafer vorgesehene BIST-Einheit (BIST = "Built in self test").

Bisher werden BIST-Techniken eingesetzt, um Selbst-Test-Schaltungen bei Chips zu realisieren, damit die Testzeit reduziert werden kann oder Schaltungen erhalten werden, welche sich selbst automatisch testen, ohne jegliche zusätzliche aufwendige externe Testausrüstung zu benötigen.

Die vorliegende Erfindung wendet nun in vorteilhafterweise Weise diese BIST-Technik auf Waferebene an, indem sie BIST-Anordnungen auf dem Wafer vorsieht, die das Durchführen von Burn-In-Behandlungen erlauben. Wesentlich an der vorliegenden Erfindung ist also die Verknüpfung von BIST-Techniken mit WLBI.

Der allgemeine Einsatz von BIST-Techniken für WLBI ist besonders vorteilhaft, da alle Signale und Muster auf dem Wafer selbst erzeugt werden und auf den Wafer vollständig kontaktierende Anordnungen, wie Nadelkarten, verzichtet werden kann. Dabei ist es beispielsweise möglich, eine einzelne BIST-Einheit für jeden Chip auf dem Wafer oder jeweils für mehrere Chips des Wafers vorzusehen. Eine solche Einheit kann dann die notwendigen Steuersignale zu dem einen Chip oder zu den mehreren Chips parallel liefern.

Wenn eine BIST-Einheit für einen Chip oder für mehrere Chips des Wafers vorgesehen wird, so können verschiedene globale Signale als Versorgungssignale, Taktsignale und Befehlssignale zu diesen Einheiten über den Wafer geführt werden. Dies ist beispielsweise möglich, indem eine zusätzliche Metallebene für die BIST-Verdrahtung vorgesehen wird.

Zwecks flächenoptimierter Realisierung werden die BIST-Einheiten im so genannten "Kerf", d.h. dem Sägerand der einzelnen Chips, untergebracht. Werden die BIST-Einheiten in den Kerf verlegt, so wird praktisch keine zusätzliche Chipfläche für die BIST-Einheiten benötigt. Vielmehr befinden sich diese BIST-Einheiten in dem Kerf, der beim Zerlegen des Wafers in die einzelnen Chips wegfällt.

Die Ergebnisse, die im WLBI erhalten sind, werden in elektrischen Fuses abgelegt, um dort für eine spätere Testausrüstung bereitgehalten zu sein. Diese Fuses sind ebenfalls im Kerf untergebracht. Außerdem ist es möglich, elektrische oder metallische Fuses im Kerf zum Programmieren der einzelnen BIST-Einheiten unterzubringen.

Die vorliegende Erfindung vermeidet die Schwierigkeiten der bestehenden Anordnungen zur Durchführung von Burn-In-Behandlungen auf Waferebene in vorteilhafter Weise und verknüpft BIST mit WLBI: Kontaktierungsprobleme, die durch Nadelkarten mit mehr als 1500 Nadeln zwangsläufig hervorgerufen werden, können vermieden werden. Dennoch ist durch den BIST ein zuverlässiges Testen der Halbleitervorrichtungen beim WLBI möglich.

Nachfolgend wird die Erfindung anhand der Zeichnung näher erläutert, in deren einziger Figur ein erfindungsgemäßes System zur Durchführung von Burn-In-Behandlungen von Halbleitervorrichtungen in Draufsicht schematisch veranschaulicht ist.

Ein Halbleiterwafer 1 besteht aus einer Vielzahl von Halbleiterchips 2, die auf diesem Wafer 1 angeordnet sind. So kann der Halbleiterwafer 1 beispielsweise 1000 Chips 2 umfassen.

Eine Einzelheit A des Halbleiterwafers 1 mit einem Chip 2 ist vergrößert im linken unteren Bereich der Figur gezeigt.

Die einzelnen Halbleiterchips 2 sind mit Bussen 4 bzw. 6 verbunden, über die an die Halbleiterchips 2 Versorgungsspannungen, Taktsignale, Befehlssignale und so weiter angelegt werden können. Hierzu sind diese Busse 4 mit Anschlüssen 5 versehen, an die Versorgungsspannungen, Taktsignale, Befehlssignale und so weiter extern anlegbar sind.

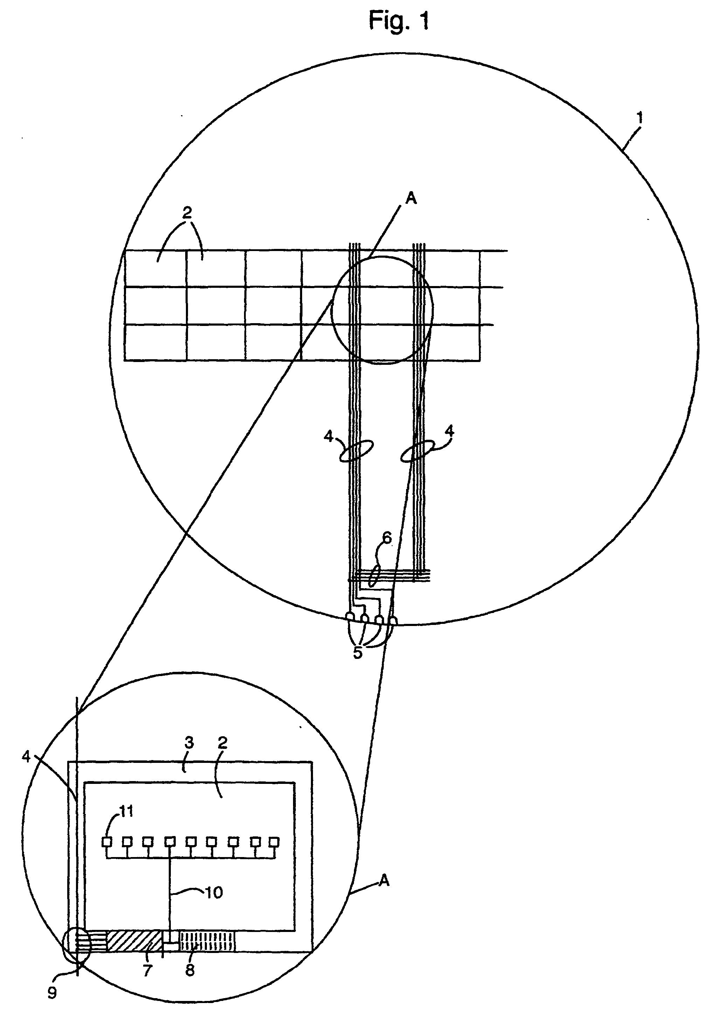

Die Busse 4 können auf einer gesonderten zusätzlichen Metallisierungsebene verlaufen. Es ist aber auch möglich, die Busse 4 gegebenenfalls in einem Kerf (Sägerand) 3, wie dies in Fig. 1 veranschaulicht ist, unterzubringen. In diesem Fall wird weder eine weitere Metallisierungsebene noch zusätzliche Fläche für die Busse benötigt.

Es ist auch möglich, auf den Halbleiterchips 2 Kontaktkissen bzw. Pads 11 vorzusehen, über die Nadeln für die durchzuführenden Burn-In-Behandlungen angelegt werden können. Mit anderen Worten, bei der erfindungsgemäßen Anordnung müssen nicht alle Nadeln durch BIST-Einheiten ersetzt werden. Vielmehr ist es durchaus möglich, eine gewisse Anzahl von Nadeln je Halbleiterchip beizubehalten und nur einen Teil der Burn-In-Behandlungen über BIST-Einheiten zu steuern. Selbstverständlich kann aber gegebenenfalls auf die Versorgung über Kontaktnadeln vollständig verzichtet werden, so dass die Burn-In-Behandlungen insgesamt über BIST-Einheiten gesteuert sind.

Die Figur veranschaulicht, wie eine solche BIST-Einheit 7 im Kerf 3 des Halbleiterchips 2 anzuordnen und über Leitungen 9 mit den Bussen 4 zu verbinden ist. Die BIST-Einheit 7 ist hier mit den Bussen 4 verbunden und an die gegebenenfalls vorhandenen Kontaktkissen 11 für Kontaktnadeln mittels einer Leitung 10 angeschlossen.

Die Erfindung schafft so also zahlreiche Möglichkeiten, wie eine BIST-Einheit den Halbleiterchips zuzuordnen ist: denkbar ist, dass eine einzige BIST-Einheit alle Halbleiterchips des Halbleiterwafers mit den entsprechenden Testprogrammen für Burn-In versorgt. Ebenso ist es möglich, jedem einzelnen Halbleiterchip 2 eine BIST-Einheit 7, im Kerf 3, zuzuordnen. Zwischen diesen beiden extremen Lösungen sind auch Zwischenlösungen denkbar, bei denen, worauf bereits hingewiesen wurde, einer BIST-Einheit mehrere Halbleiterchips zugeordnet sind.

Ebenso gibt es verschiedene Möglichkeiten zum Zuführen der Versorgungsspannungen, Befehlssignale, Steuersignale, Taktsignale und so weiter: diese können über die Busse 4 oder über die Kontaktkissen 11 angelegt werden. Bevorzugt wird eine Lösung, bei der auf die Kontaktkissen 11 verzichtet werden kann. In diesem Fall werden keine Nadelkarten benötigt, und die gesamte Testschaltung ist in dem Halbleiterwafer, gegebenenfalls in einer weiteren Metallisierungsebene, realisiert.

Burn-In-Testergebnisse werden in elektrischen Fuses 8 abgelegt, die ebenfalls im Kerf 3 unterzubringen sind. Bei dem in der Figur gezeigten System sind die Fuses 8 jeweils für jeden Halbleiterchip 2 vorgesehen, so dass eine in hohem Maße dezentralisierte Organisation realisierbar ist. Hier führt jede BIST-Einheit 7 an dem ihr zugeordneten Halbleiterchip 2 die Burn-In-Behandlungen durch.

In den Fuses 8 im Kerf 3 abgelegte Testergebnisse können gegebenenfalls vor einem Zerlegen des Halbleiterwafers 1 in die einzelnen Halbleiterchips 2 in einem externen Speicher abgelegt werden.

Die Fuses 8 können bei Bedarf programmierbar sein. Dies macht es möglich, die durch die BIST-Einheiten 7 zu absolvierenden Behandlungsprogramme zu verändern, so dass die Anordnung insgesamt in hohem Maße flexibel ist, da die auszuführenden Behandlungen durch Laser-Fusen ohne Maskenänderungen auf der Ebene der BIST-Einheiten an den jeweiligen Bedarf angepasst werden können.

Zweckmäßigerweise ist jede BIST-Einheit mit den externen Anschlüssen der einzelnen Chips 2 verbunden, damit dieser als einzelner Baustein getestet werden kann. Es sind jedoch auch andere Verbindungen innerhalb der Halbleiterchips 2 möglich. Jedenfalls können die Verbindungen zwischen der BIST-Einheit 7 und den einzelnen Anschlüssen des Halbleiterchips 2 auf den ohnehin vorhandenen Metallisierungsebenen oder auch auf zusätzlichen Metallisierungsebenen erfolgen. Laserfuses können gegebenenfalls verwendet werden, um die BIST-Einheit 7 von dem Halbleiterchip 2 zu trennen, nachdem die Burn-In-Behandlung abgeschlossen ist, damit die kapazitive Belastung an den Anschlüssen des Chips reduziert wird.

## Patentansprüche

1. System, umfassend einen Halbleiterwafer sowie eine Anordnung zur Durchführung von Burn-in-Behandlungen an einer Vielzahl von im Halbleiterwafer (1) enthaltenen Halbleiterchips (2), wobei bei einer Burn-in-Behandlung die in den Halbleiterchips (2) realisierten integrierten Schaltungen und Bauteile bei erhöhter Temperatur bestimmten, von außen zugeführten Spannungen ausgesetzt sind und die Anordnung eine Mehrzahl von BIST-Einheiten umfasst, so dass allen Halbleiterchips (2) jeweils eine BIST-Einheit (7) zugeordnet ist,
**dadurch gekennzeichnet, dass**
- die BIST-Einheiten (7) im Kerf (9) der Halbleiterchips (2) vorgesehen sind.
- Versorgungsspannung, Takt-, Befehls- und Steuersignale jeder BIST-Einheit (7) durch auf dem Halbleiterwafer (1) im Kerf (3) geführte Leitungen (4) zugeführt sind,
- Burn-In-Testergebnisse in ebenfalls im Kerf (3) vorgesehenen elektrischen Fuses (8) für eine spätere Auswertung abspeicherbar sind, und
- die BIST-Einheiten (7) über die im Kerf (3) vorgesehenen Fuses (8) programmierbar sind.

2. System nach Anspruch 1,
**dadurch gekennzeichnet, dass**
jeweils ein Halbleiterchip (2) und jeweils eine BIST-Einheit (7) ausschließlich einander zugeordnet sind.

3. System nach Anspruch 1,
**dadurch gekennzeichnet, dass**
jeweils eine Mehrzahl von Halbleiterchips (2) und jeweils eine BIST-Einheit (7) ausschließlich einander zugeordnet sind.

4. System nach Anspruch 2 oder 3,
**dadurch gekennzeichnet, dass**
Versorgungsspannung, Takt-, Befehls- und Steuersignale den BIST-Einheiten (7) auch über auf den Halbleiterchips (2) vorgesehene Kontaktkissen (11) zuführbar sind.

5. System nach einem der Ansprüche 2 bis 4,
**dadurch gekennzeichnet, dass**
für die BIST-Einheiten gesonderte Metallisierungsebenen vorgesehen sind.

## Claims

1. System comprising a semiconductor wafer and an arrangement for carrying out burn-in processing operations on a multiplicity of semiconductor chips (2) contained in the semiconductor wafer (1), where a burn-in processing operation involves the integrated circuits and components produced in the semiconductor chips (2) being exposed to particular externally supplied voltages at a raised temperature and the arrangement comprises a plurality of BIST units, so that all the semiconductor chips (2) have a respective associated BIST unit (7),
**characterized in that**
- the BIST units (7) are provided in the kerf (9) of the semiconductor chips (2),
- supply voltage, clock, command and control signals are supplied to each BIST unit (7) by lines (4) routed on the semiconductor wafer (1) in the kerf (3),
- burn-in test results can be stored in electrical fuses (8), likewise provided in the kerf (3), for later evaluation, and
- the BIST units (7) can be programmed using the fuses (8) provided in the kerf (3).

2. System according to Claim 1,
**characterized in that** a respective semiconductor chip (2) and a respective BIST unit (7) are exclusively associated with one another.

3. System according to Claim 1,
**characterized in that** a respective plurality of semiconductor chips (2) and a respective BIST unit (7) are exclusively associated with one another.

4. System according to Claim 2 or 3, **characterized in that** supply voltage, clock, command and control signals can be supplied to the BIST units (7) also via contact pads (11) provided on the semiconductor chips (2).

5. System according to one of Claims 2 to 4, **characterized in that** separate metallization planes are provided for the BIST units.

## Revendications

1. Système comprenant une tranche semi-conductrice ainsi qu'un dispositif pour effectuer des traitements burn-in sur une pluralité de puces (2) à semi-conducteurs contenues dans la tranche (1) semi-conductrice, dans lequel, lors d'un traitement burn-in, les circuits intégrés et les composants réalisés dans les puces (2) à semi-conducteurs sont soumis, à une température élevée, à des tensions déterminées appliquées de l'extérieur et le dispositif comprend une multiplicité d'unités BIST, de sorte que, respectivement, une unité (7) BIST est associée à toutes les puces (2) à semi-conducteurs,
**caractérisé en ce que**
- les unités (7) BIST sont prévues dans le bord de sciage (3) des puces (2) à semi-conducteurs ;
- des signaux de tension d'alimentation, de cadence, d'instruction et de commande de chacune des unités (7) BIST sont envoyés par des lignes (4) passant dans le bord de sciage (3) sur la tranche (1) semi-conductrice ;
- les résultats d'essai de burn-in sont mémorisés pour une exploitation ultérieure dans des fusibles (8) électriques prévus dans le bord de sciage (3) ; et
- les unités (7) BIST peuvent être programmées par l'intermédiaire des fusibles (8) prévus dans le bord de sciage (3).

2. Système suivant la revendication 1, **caractérisé en ce que**, respectivement, une puce (2) à semi-conducteurs et, respectivement, une unité (7) BIST sont associées exclusivement l'une à l'autre.

3. Système suivant la revendication 1, **caractérisé en ce que**, respectivement, une pluralité de puces (2) à semi-conducteurs et, respectivement, une unité (7) BIST sont associées, respectivement, l'une à l'autre.

4. Système suivant la revendication 2 ou 3, **caractérisé en ce que** des signaux de tension d'alimentation, de cadence, d'instruction et de commande peuvent être envoyés aux unités (7) BIST également par l'intermédiaire de coussins (11) de contact prévus sur les puces (2) à semi-conducteurs.

5. Système suivant l'une des revendications 2 à 4, **caractérisé en ce qu'**il est prévu des plans de métallisation particuliers pour les unités BIST.
